# EUROPÄISCHE PATENTANMELDUNG

(11) **EP 0 987 556 A2**
(43) Veröffentlichungstag der Anmeldung: **22.03.2000**
(21) Anmeldenummer: 99115516.9
(22) Anmeldetag: 05.08.1999
(51) Int. Cl.: G01R 31/265, H01L 21/66

(54) **Vorrichtung zur Diffusionslängenmessung in Halbleiterkörpern**

(30) Priorität: 10.08.1998 DE 19836131
(71) Anmelder: SIEMENS AKTIENGESELLSCHAFT, 80333 München (DE); EUPEC Europäische Gesellschaft für Leistungshalbleiter mbH & Co. KG, 59581 Warstein-Belecke (DE)
(72) Erfinder: Otto, Johann, 83646 Bad Tölz (DE); Bommersbach, Renate, 80689 München (DE); Schulze, Hans-Joachim, Dr., 85521 Ottobrunn (DE); Baur, Bernd, 80803 München (DE)

(57) **Zusammenfassung**

Zwischen zwei Meßhalbkammern zur Durchführung des Elymatverfahrens wird ein Probenhalter mit einem Halbleiterkörper (31) angeordnet, der die Kammern gegeneinander abdichtet. Der Probenhalter besteht aus zwei voneinander trennbaren Teilen (11, 12) mit einer Öffnung (21, 22) in der Mitte, in die der Halbleiterkörper eingesetzt wird. In Nuten (51, 52) längs der inneren Ränder (41, 42) sind Dichtungen (61, 62) eingefügt, so daß der Halbleiterkörper die Öffnung abdichtet. An den inneren Rändern sind die Teile auf den inneren Seitenflächen (71, 72) ausgespart, um den Halbleiterkörper aufnehmen und zentrieren zu können.

## Beschreibung

Die vorliegende Erfindung betrifft eine Vorrichtung zur Anwendung des sogenannten Elymatverfahrens, mit dem man z. B. die Diffusionslängen in Halbleitermaterialien messen kann.

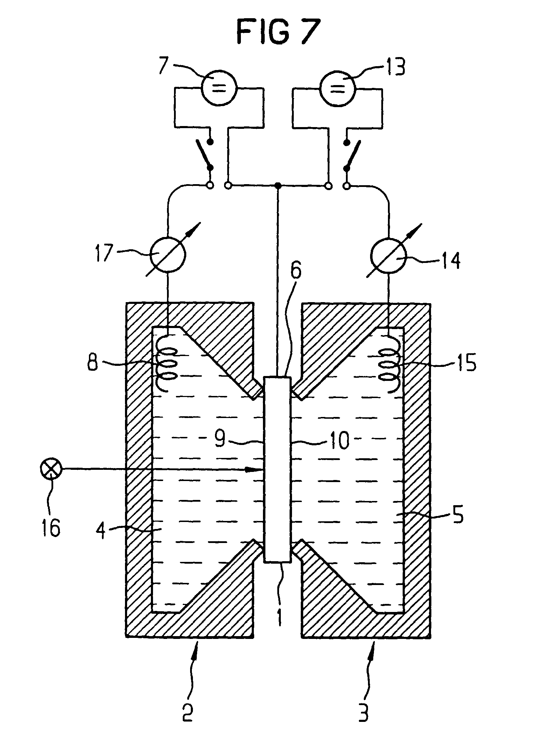

In der EP 0 400 373 B1 ist ein Verfahren zur ortsaufgelösten Bestimmung der Diffusionslänge der Minoritätsladungsträger in einem Halbleiterkristallkörper beschrieben. Eine Vorrichtung, mit der dieses Verfahren ausgeführt werden kann, ist im Schema in der beigefügten Figur 7 dargestellt. Ein zu messender Wafer 1, z. B. eine Siliziumscheibe, wird zwischen zwei mit einem Elektrolyten 4, 5 gefüllten Meßhalbkammern 2, 3 so angeordnet, daß die Meßhalbkammern gegeneinander abgedichtet sind, die Elektrolyten also innerhalb der jeweiligen Kammer eingeschlossen sind. Der Wafer wird über einen ohmschen Kontakt 6 mit einer Spannungsquelle 7 verbunden; der andere Pol der Spannungsquelle 7 ist an eine Elektrode 8 angeschlossen, die in den Elektrolyten 4 der ersten Meßhalbkammer 2 eintaucht. Die Spannung wird so eingestellt, daß sich an der Oberseite 9 des Wafers, die der ersten Meßhalbkammer 2 zugewandt ist, eine sperrende Raumladungszone bildet. Diese Oberseite 9 des Wafers wird mit einer Lichtquelle 16 beleuchtet, die eine Wellenlänge oberhalb 800 nm ausstrahlt. Der Fotostrom der Minoritätsladungsträger wird mit einem Ampèremeter 17 gemessen. Daraus kann die zu messende Diffusionslänge bestimmt werden. Die zweite Meßhalbkammer 3, der die gegenüberliegende Oberseite 10 des Wafers zugewandt ist, kann über eine weitere Elektrode 15, die in den Elektrolyten 5 der zweiten Meßhalbkammer 3 eintaucht, mit einer Spannungsquelle 13 in der Weise beschaltet werden, daß an dieser Oberseite 10 des Wafers eine sperrende Raumladungszone entsteht. Dann kann der Rückseitenfotostrom von Minoritätsladungsträgern mit einem weiteren Ampèremeter 14 gemessen werden und ebenfalls zur Bestimmung der Diffusionslänge herangezogen werden.

Zur Ausführung des Verfahrens sind inzwischen sogenannte Elymatapparaturen gebräuchlich, in denen für Wafer unterschiedlicher Größen verschiedene Kammern verwendet werden. Die Kammern sind jeweils so gestaltet, daß die Abmessungen des für die Aufnahme einer Probe vorgesehenen Teils der Kammer dem Durchmesser und der Dicke des jeweiligen Wafers angepaßt ist. Die Wafer haben üblicherweise Durchmesser von z. B. 3, 4 oder 5 Zoll oder 84 mm und unterschiedliche Dicken von z. B. 400 µm bis 2200 µm. Nachteilig ist dabei, daß die Kammern teuer sind und der Wechsel der Kammern zeitaufwendig ist. Außerdem haben die kreisförmigen Dichtungen, die den Wafer halten und die Meßhalbkammern abschließen, den Nachteil, daß bei Siliziumscheiben mit Flats (geradlinigen Anteilen der Berandung) ein relativ großer Anteil des Außenbereichs nicht gemessen werden kann.

Aufgabe der vorliegenden Erfindung ist es, eine Vorrichtung anzugeben, mit der auf einfache Weise eine Diffusionslängenmessung für Halbleiterkörper unterschiedlicher Abmessungen durchgeführt werden kann.

Diese Aufgabe wird mit der Vorrichtung mit den Merkmalen des Anspruches 1 oder 2 bzw. durch Verwendung eines Probenhalters mit den Merkmalen des Anspruches 6 in einer für das Elymatverfahren vorgesehenen Vorrichtung gelöst. Ausgestaltungen ergeben sich aus den abhängigen Ansprüchen.

Die erfindungsgemäße Vorrichtung umfaßt eine als Meßkammer für die Aufnahme eines Halbleiterkörpers und eines Elektrolyten vorgesehene Kammer, die vorzugsweise aus zwei voneinander trennbaren Meßhalbkammern gebildet ist, und ist für die Durchführung eines dem eingangs beschriebenen Elymatverfahren ähnlichen Meßverfahrens vorgesehen. Die Abmessungen der Meßkammer sind so groß, daß die größten für eine Messung vorgesehenen Halbleiterkörper darin aufgenommen werden können. Zu dieser Kammer stehen eine Mehrzahl von Probenhaltern zur Verfügung, in die je ein Halbleiterkörper bestimmter geometrischer Abmessungen (Größe und Form) eingesetzt werden kann. Ein solcher Probenhalter kann in die Kammer so eingesetzt werden, daß beidseitig Meßhalbkammern gebildet werden, die durch den Probenhalter und den darin eingesetzten Halbleiterkörper voneinander getrennt werden. Die Probenhalter sind vorzugsweise aus zwei Teilen zusammengesetzt, die rahmen- oder ringförmig mit einer Öffnung oder Aussparung in der Mitte ausgebildet sind und voneinander getrennt werden können, so daß in die Öffnung und den inneren Rand des Rahmens oder Ringes ein Halbleiterkörper eingesetzt werden kann. Der Rahmen oder Ring ragt mit dem inneren Rand vorzugsweise ringsum nur wenige Millimeter über den Rand des Halbleiterkörpers, so daß der Halbleiterkörper zwar sicher und dicht gehalten wird, aber die Oberflächen des Halbleiterkörpers fast nicht abgedeckt werden. Der Probenhalter ist vorzugsweise aus einem Material, das ausreichend fest und gegen den vorgesehenen Elektrolyten beständig sowie für die vorgesehenen Wellenlängen des einzustrahlenden Lichtes ausreichend undurchlässig ist (z. B. dunkelgraues oder anthrazitfarbenes Polyvinylchlorid). Vorzugsweise sind in die Teile des Probenhalters längs der inneren Ränder Dichtungen eingelassen, die die beiden Meßhalbkammern jeweils zwischen dem Probenhalter und der Probe abdichten.

Es folgt eine Beschreibung typischer Ausführungsbeispiele des Probenhalters, aus denen die prinzipielle Gestaltung der erfindungsgemäßen Vorrichtung einschließlich möglicher Abwandlungen deutlich wird, anhand der Figuren 1 bis 6.
Figuren 1 und 2 zeigen zwei verschiedene Ausführungen für den Probenhalter im Querschnitt.
Figuren 3 und 4 zeigen zwei verschiedene Ausführungen für das erste Teil des in Figur 1 dargestellten Probenhalters in Aufsicht auf die Innenseite.
Figuren 5 und 6 zeigen je ein Schema eines Ausführungsbeispieles der erfindungsgemäßen Vorrichtung.
Figur 7 zeigt ein Schema der eingangs beschriebenen Vorrichtung aus dem Stand der Technik.

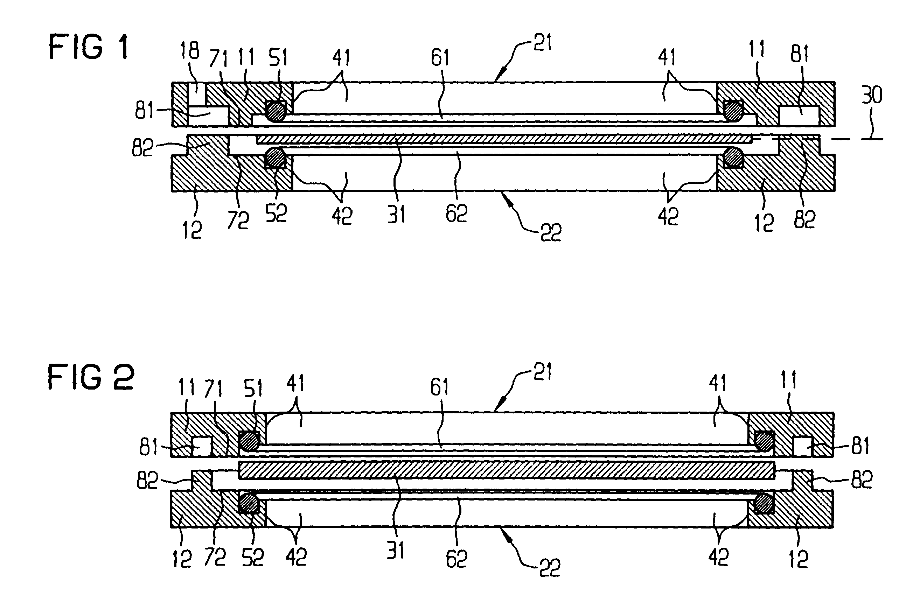

Die Figuren 1 und 2 zeigen je ein Ausführungsbeispiel eines Probenhalters mit Probe im Querschnitt. Die Probenhalter sind aus zwei Teilen 11, 12 zusammengesetzt, die in der Mitte eine Öffnung 21, 22 von vorzugsweise fast der Größe und Form des als Probe vorgesehenen Halbleiterkörpers 31 besitzen. Diese Öffnung 21, 22 kann grundsätzlich in beliebiger geometrischer Form berandet sein und ist vorzugsweise an die Abmessungen des für die Messung vorgesehenen Halbleiterkörpers angepaßt; die inneren Rändern 41, 42 der Teile 11, 12 haben daher vorzugsweise dieselbe Form. In vorzugsweise gleichbleibend geringem Abstand zu den inneren Rändern 41, 42 sind in der dem jeweils anderen Teil zugewandten Seitenfläche jedes Teiles Nuten 51, 52 (Dichtungsnuten oder Rillen) vorhanden, in die Dichtungen 61, 62, z. B. aus Gummi oder Viton®, eingesetzt sind. In den Figuren sind von den Dichtungen 61, 62 jeweils ein runder Querschnitt in dem Querschnitt der Nuten 51, 52 sowie der den inneren Rand 41, 42 hinter der Zeichenebene überragende Anteil erkennbar. Die Nuten 51, 52, in denen die Dichtungen angebracht sind, können statt einer rechteckigen auch eine trapezförmig hinterschnittene Querschnittsform aufweisen, so daß die Dichtungen sicher gehalten werden und in den Nuten ein überschüssiges Volumen vorhanden ist, in das die Dichtungen beim Zusammensetzen der Teile mit der Probe hineingedrückt werden können.

An zumindest einem Teil des Probenhalters kann in der dem anderen Teil zugewandten Seitenfläche ein den Bereich der Dichtung einschließender Flächenanteil am inneren Rand gegenüber der Ebene dieser Seitenfläche etwas zurückgesetzt sein, so daß das Teil dort etwas dünner ist. Das betrifft die Seitenfläche 71 von Teil 11 bei dem Ausführungsbeispiel der Figur 1 und die Seitenfläche 71 von Teil 11 sowie die Seitenfläche 72 von Teil 12 bei dem Ausführungsbeispiel der Figur 2. Beim Zusammensetzen der Teile 11, 12 ohne eingesetzte Probe werden die Seitenflächen 71, 72 aufeinandergesetzt. Es bleibt in dem besagten Flächenanteil an den inneren, der Öffnung 21, 22 zugewandten Rändern 41, 42 zwischen den Teilen ein sehr dünner Zwischenraum, der mindestens der minimalen Dicke der als Probe vorgesehenen Halbleiterkörper 31 entspricht. Der besagte Flächenanteil besitzt grundsätzlich eine beliebige, aber vorzugsweise eine eher geringe Breite ― senkrecht vom inneren Rand aus gemessen ―, so daß dieser Flächenanteil zusammen mit der Öffnung in etwa die Fläche des einzusetzenden Halbleiterkörpers einnimmt und die Öffnung möglichst groß ist. In diesem Fall wird der Halbleiterkörper beim Einsetzen durch die Flanke, die den hinter die Ebene der betreffenden Seitenfläche zurückspringenden Flächenanteil begrenzt (Zentrierstufe oder Zentrierrand), automatisch richtig zentriert, und die der Messung zugängliche Oberfläche des Halbleiterkörpers ist möglichst groß.

In den Figuren 1 und 2 ist außerdem ein jeweils auf einem Teil (hier als Beispiel Teil 12) des betreffenden Probenhalters vorhandener Aufsatz 82, der vorzugsweise integraler Bestandteil des Teiles ist, eingezeichnet. Dieser Aufsatz oder Ansatz kann durch einen Wulst oder Ring, durch Noppen, Stege oder dergleichen gebildet sein und greift in eine entsprechende Nut 81 in dem anderen Teil (hier Teil 11) ein. Mit diesen ineinandergreifenden Oberflächenstrukturen, die auch weggelassen sein können, wird erreicht, daß die Teile 11, 12 beim Zusammensetzen zentriert werden. Der Ansatz 82 und die zugehörige Nut 81 sollen in der Richtung senkrecht zur jeweiligen Seitenfläche 71, 72 eine so große Abmessung aufweisen, daß die Teile auch dann richtig zentriert werden, wenn ein Halbleiterkörper 31 als Probe eingesetzt wird, der eine deutlich größere als die minimale vorgesehene Dicke aufweist.

In dem Ausführungsbeispiel der Figur 1 ist eine Anzahl von Abflußöffnungen 18 ( 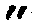 bleeding") in dem ersten Teil 11 vorhanden, die in der der Zentrierung dienenden Nut 81 ausgebildet sind. Durch diese Abflußöffnungen kann im Fall einer unzureichenden Abdichtung zwischen dem Halbleiterkörper und dem Probenhalter sich in der Nut ansammelnder Elektrolyt sowie eine ggf. verwendete Spülflüssigkeit abfließen.

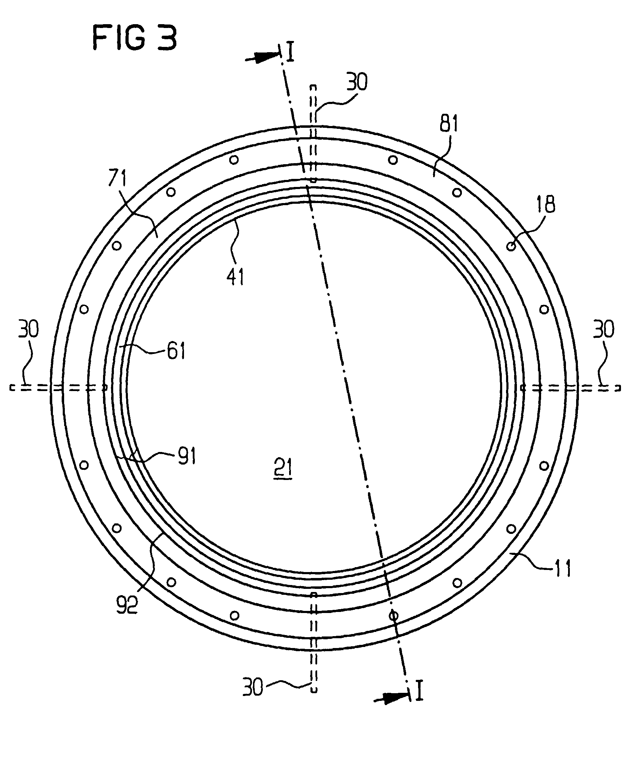

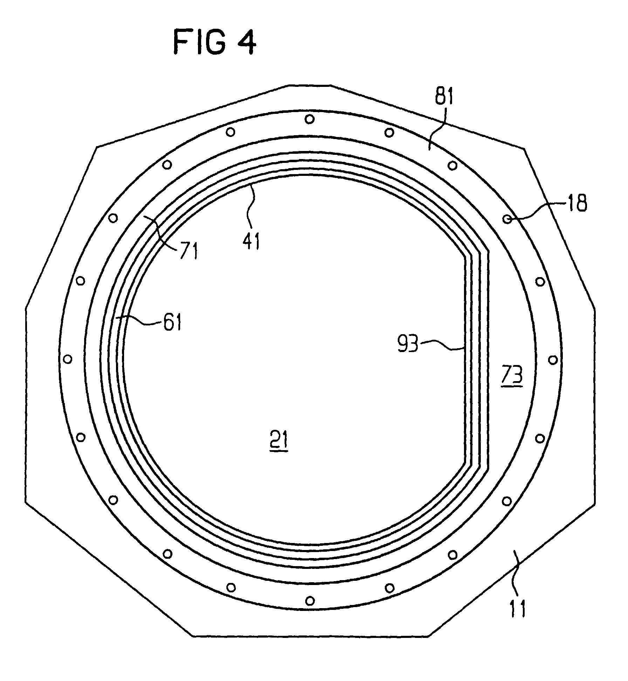

Figur 3 zeigt das Teil 11 des in Figur 1 dargestellten Ausführungsbeispieles in Blickrichtung auf die Seitenfläche 71. Die Öffnung 21 ist in dem Ausführungsbeispiel rund. Die Dichtung 61 ist kreisförmig längs des Randes 41 der Öffnung angebracht. In der Seitenfläche 71 ist die der Zentrierung dienende Nut 81 mit den Abflußöffnungen 18 ausgebildet. Die Nut ist in diesem Beispiel kreisringförmig. Der den Bereich der Dichtung 61 einschließende Flächenanteil 91, der gegenüber der Ebene der Seitenfläche 71 etwas zurückgesetzt ist, ist hier deutlich erkennbar. Eine Halbleiterscheibe von etwa der Fläche der Öffnung 21 und diesem Flächenanteil 91 kann in dieses Teil eingesetzt werden und wird durch die Flanke der Seitenfläche 71 an der äußeren Begrenzung 92 des besagten Flächenanteils 91 zentriert. Wie bereits erwähnt, muß die Öffnung 21 nicht rund sein. Ebenso braucht die äußere Berandung des Probenhalters nicht wie hier der Einfachheit halber gezeichnet kreisförmig zu sein, sondern kann den jeweiligen Anforderungen und den Ausgestaltungen der Meßhalbkammern angepaßt sein. Eine Ausführungsform des Probenhalters mit nicht kreisförmiger äußerer Berandung ist anhand des entsprechenden Teils in Aufsicht in Figur 4 dargestellt. In diesem Beispiel ist auch die innere Öffnung 21 nicht kreisförmig, sondern für Halbleiterkörper mit Flats an einer Seite mit einer geradlinigen Begrenzung 93 versehen (der Deutlichkeit halber übertrieben lang eingezeichnet). Entsprechend ist vorzugsweise die Dichtung 61 in gleichem Abstand längs dieser geradlinigen Begrenzung 93 geführt. Die Seitenfläche 71 hat einen größerflächigen Anteil 73 im Bereich der geradlinigen Begrenzung der Öffnung 21, wenn eine selbsttätige Ausrichtung des Halbleiterkörpers mit dem Flat auf der entsprechenden Seite gewünscht ist; die Seitenfläche 71 kann der einfacheren Herstellbarkeit wegen aber auch wie bei der Ausführungsform der Figur 3 eine kreisförmige Stufe zum Halbleiterkörper hin aufweisen.

Typische Abmessungen des Probenhalters sind zum Beispiel eine Dicke der Teile 11, 12 von je 5 mm, ein gesamter Durchmesser von 160 mm und eine Breite und Tiefe der für die Aufnahme der Dichtungen 61, 62 vorgesehenen Nuten 51, 52 von 1,7 mm bzw. 1,5 mm, so daß torusförmige Dichtungsringe etwa 0,2 mm aus der Nut überstehen. Für die aufzunehmenden Halbleiterkörper kann eine minimale Dicke von z. B. 0,6 mm vorgesehen sein. Der Probenhalter kann für die Aufnahme von Halbleiterkörpern mit einem Scheibendurchmesser von 300 mm ausgebildet sein. Der Durchmesser der inneren Öffnung 21 des Probenhalters kann im Prinzip beliebig klein sein. Die Verwendung verschiedener Probenhalter unterschiedlich abgemessener Öffnungen ermöglicht es daher auf einfache Weise, auch sehr kleine Halbleiterkörper in einer Meßvorrichtung, die für große Scheibendurchmesser eingerichtet ist, zu messen. Dazu wird nur der Probenhalter ausgetauscht.

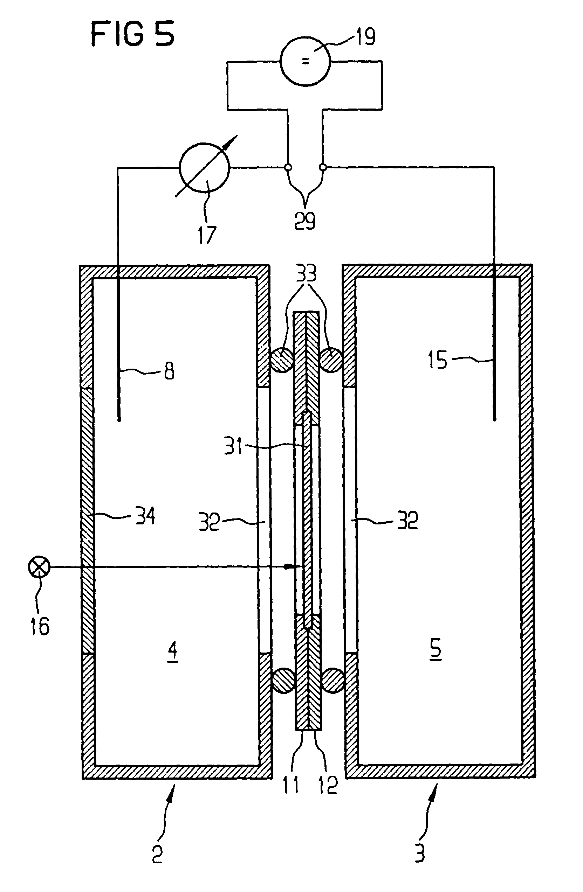

Die erfindungsgemäße Vorrichtung mit dem beschriebenen Probenhalter sieht im Unterschied zu dem eingangs beschriebenen herkömmlichen Meßverfahren nur eine Messung der Ströme durch die Elektrolyten auf der Vorderseite und auf der Rückseite des Halbleiterkörpers vor, nicht aber eine Messung zwischen Elektrolyt und Halbleiterkörper. Ohne den ohmschen Kontakt 6 (Nadelkontakt, Figur 5) am Halbleiterkörper lassen sich sowohl FPC-Messungen (forward photo current) als auch BPC-Messungen (backward photo current) nur an n-leitend dotierten Halbleiterkörpern durchführen, während an p-leitend dotierten Halbleiterkörpern nur FPC-Messungen möglich sind. Werden auch BPC-Messungen an p-leitend dotierten Halbleiterkörpern gefordert, muß der Probenhalter mit einem entsprechenden Kontakt versehen werden, z. B. mit einer Nadel 30 (s. Figuren 1 und 3, dort jeweils gestrichelt eingezeichnet). Es können mehrere solcher Nadeln 30 an der Peripherie des Halbleiterkörpers, und zwar außerhalb der Dichtungen 61, 62 ohne Kontakt mit dem Elektrolyten vorhanden sein, wie das andeutungsweise in Figur 3 mit vier Nadeln dargestellt ist. Die Nadeln müssen mit dem Halbleiterkörper einen elektrischen Kontakt bilden, der zumindest in der jeweiligen Richtung des zu messenden Stromes ausreichend niederohmig ist; das ist vorzugsweise ein ohmscher Kontakt. Sie besitzen einen elektrischen Anschluß zu einer Spannungsquelle und sind daher vorzugsweise untereinander elektrisch leitend verbunden. Statt der Nadeln können anders gestaltete Kontaktelemente in entsprechender Anordnung in dem Probenhalter vorhanden sein, z. B. ein leitfähiger, eventuell federnd ausgebildeter Kranz, der im Inneren der Zentrierstufe derart längs der Zentrierstufe angeordnet ist, daß ein elektrischer Kontakt zu einem eingesetzten Halbleiterkörper vorgesehener Größe hergestellt wird. Die Nadel 30 kann im Inneren des Teiles 11 angebracht sein oder z. B. in einer Nut in dessen äußerer oder innerer Seitenfläche 71; wichtig ist, daß die Dichtung 61 nicht unterbrochen wird. In dem speziellen Fall einer Messung über einen elektrischen Kontakt am Halbleiterkörper genügt es, wenn eines der Teile, aus denen der Probenhalter zusammengesetzt ist, ohne die Öffnung 21 bzw. 22 in der Mitte ausgebildet ist. Ein solcher Probenhalter wird dann ausschließlich für die Messung des Stromes durch einen Elektrolyten auf nur einer Seite des Halbleiterkörpers verwendet.

Figur 5 zeigt die Anordnung der erfindungsgemäßen Vorrichtung in einem schematischen Querschnitt. Die mit Elektrolyt 4, 5 gefüllten Meßhalbkammern 2, 3 sind mit Öffnungen 32 versehen, zwischen denen der Probenhalter 11, 12 mit dem eingesetzten Halbleiterkörper so angebracht wird, daß die Meßhalbkammern gegeneinander und nach außen abgedichtet sind. Für die Abdichtung sorgen vorzugsweise die standardmäßig an den Meßhalbkammern angebrachten Dichtungen 33 zwischen dem Probenhalter und je einer Außenseite der Meßhalbkammern. Eine elektrische Spannung 19 wird an die Anschlüsse 29 angelegt und der Strom, der über die in die Elektrolyten eintauchenden Elektroden 8, 15 fließt, gemessen, was mit dem eingezeichneten Meßinstrument 17 angedeutet ist.

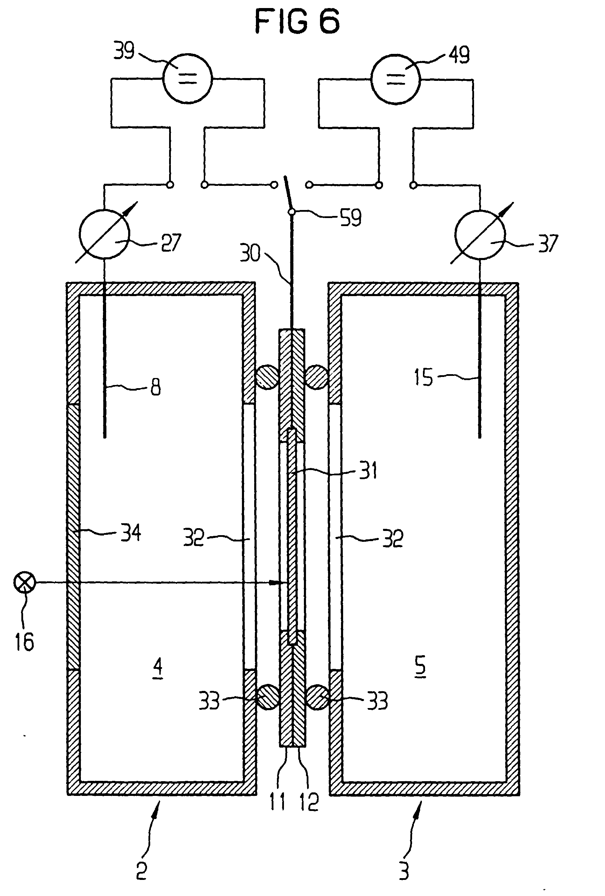

In Figur 6 ist ein weiteres Ausführungsbeispiel dargestellt, bei dem ein elektrischer Kontakt, vorzugsweise ein ohmscher Kontakt, an dem Halbleiterkörper durch einen in dem Probenhalter abgebrachten Nadelkontakt 30 gebildet wird, so daß bei Anlegen einer Spannung 39, 49 zwischen einer der Elektroden 8, 15 und dem Anschluß 59 des Nadelkontaktes 30 z. B. mittels des Meßinstrumentes 27 bzw. 37 der Strom, der über den Halbleiterkörper und die betreffende Elektrode fließt, gemessen werden kann. Es braucht sich in diesem Fall nur in einer Meßhalbkammer ein Elektrolyt zu befinden. Der jeweilige Anschluß des Nadelkontaktes an die Spannungsquelle wird z. B. über einen Schalter 59 hergestellt. Dieser Schalter kann auch so konzipiert sein, daß der Nadelkontakt abgeschaltet werden kann und die übrigen Anschlüsse kurzgeschlossen werden, um auch eine Messung entsprechend der Beschreibung zu Figur 5 durchführen zu können.

Im Prinzip kann die Vorrichtung auch durch eine Kammer gebildet sein, in die der Probenhalter z. B. in Führungsrinnen mit Dichtungen eingesetzt werden kann, so daß zwei Halbkammern gebildet werden. Die beschriebene Ausführungsform hat den Vorteil einfacher Handhabbarkeit. Das Material der Kammer ist für die vorgesehene Wellenlänge durchlässig, oder es ist an einer geeigneten Stelle ein Fenster 34 aus einem durchlässigen Material in der Kammerwand eingelassen.

Die erfindungsgemäße Vorrichtung ist mit derartigen Probenhaltern versehen, die in der Kammer relativ schnell angebracht werden können. Die Probenhalter sind mit unterschiedlichen geometrischen Formen der inneren Öffnung versehen, die auf die vorgesehenen Halbleiterkörper abgestimmt sind. Daher können verschiedene Halbleiterscheiben in derselben Kammer nach dem Elymatverfahren ausgemessen werden. Der jeweils geeignete Probenhalter nimmt die Halbleiterscheibe auf und wird in die Kammer eingebracht, und zwar bei der bevorzugten Ausführungstorin mit zwei Meßhalbkammern, indem der Probenhalter zwischen den Meßhalbkammern so eingeklemmt wird, daß die Meßhalbkammern gleichzeitig abgedichtet werden. Werden die erfindungsgemäßen Probenhalter geeignet ausgestaltet, können sie in Verbindung mit handelsüblichen Meßapparaturen zur Ausführung des Elymatverfahrens verwendet werden.

Vorzugsweise wird nur ein schmaler Streifen längs des Randes der Halbleiterscheibe von dem Probenhalter abgedeckt. Das ist insbesondere bei der Messung der Ladungsträgerlebensdauer von Siliziumscheiben, die für die Produktion von Großleistungshalbleitern eingesetzt werden, von großer Bedeutung, da sich im Randbereich der Siliziumscheiben i. a. die Randabschlüsse der hochsperrenden pn-Übergänge der Bauelemente befinden. Diese Bereiche sind im Hinblick auf eine Kontamination mit Schwermetall kritisch, da dort die höchsten elektrischen Feldstärken auftreten. Mit einem geeignet dimensionierten erfindungsgemäßen Probenhalter lassen sich die erforderlichen Messungen durchführen.

## Patentansprüche

1. Vorrichtung zur Diffusionslängenmessung in Halbleiterkörpern,
- bei der zwei Kammern (2, 3) zur Aufnahme von Elektrolyten (4, 5) vorhanden sind,
- bei der im Innern jeder Kammer (2, 3) je eine Elektrode (8, 15) vorhanden ist, die mit einem nach außen geführten Anschluß (29) versehen ist und die so angeordnet ist, daß sie mit einem eingebrachten Elektrolyten (4, 5) in Kontakt kommt,
- bei der mindestens ein Probenhalter (11, 12) vorhanden ist, der eine Öffnung (21, 22) besitzt und so gestaltet ist, daß ein Halbleiterkörper (31) vorgegebener Abmessungen so in dem Probenhalter befestigt werden kann, daß beidseitige Oberflächen des Halbleiterkörpers frei bleiben und daß der Halbleiterkörper die Öffnung verschließt und für den vorgesehenen Elektrolyten abdichtet,
- bei der der Probenhalter mit einem eingesetzten Halbleiterkörper so in oder an den Kammern angebracht werden kann, daß in jede Kammer ein Elektrolyt derart eingebracht werden kann, daß er jeweils nur mit einer Oberfläche des Halbleiterkörpers in Kontakt kommt,
- bei der Mittel vorhanden sind, mit denen Licht auf die Oberfläche des Halbleiterkörpers eingestrahlt werden kann, und
- bei der Mittel vorhanden sind, mit denen eine elektrische Spannung zwischen die Elektroden (8, 15) angelegt werden kann und ein elektrischer Strom zwischen den Elektroden gemessen werden kann.

2. Vorrichtung zur Diffusionslängenmessung in Halbleiterkörpern,
- bei der mindestens eine Kammer (2) zur Aufnahme eines Elektrolyten (4) vorhanden ist,
- bei der mindestens eine Elektrode (8) im Innern der Kammer (2) vorhanden ist, die mit einem nach außen geführten Anschluß versehen ist und die so angeordnet ist, daß sie mit einem eingebrachten Elektrolyten (4) in Kontakt kommt,
- bei der mindestens ein Probenhalter (11, 12) vorhanden ist, der eine Öffnung (21, 22) besitzt und so gestaltet ist, daß ein Halbleiterkörper (31) vorgegebener Abmessungen so in dem Probenhalter befestigt werden kann, daß mindestens eine Oberfläche des Halbleiterkörpers frei bleibt und daß der Halbleiterkörper die Öffnung verschließt und für den vorgesehenen Elektrolyten abdichtet,
- bei der elektrisch leitende Mittel in oder an dem Probenhalter vorhanden sind, mit denen ein elektrischer Kontakt an einen eingesetzten Halbleiterkörper vorgesehener Abmessungen hergestellt wird,
- bei der der Probenhalter mit einem eingesetzten Halbleiterkörper so in oder an der Kammer angebracht werden kann, daß ein Elektrolyt derart in die Kammer eingebracht werden kann, daß er nur mit einer Oberfläche des Halbleiterkörpers außerhalb der für den elektrischen Kontakt vorgesehenen Mittel in Kontakt kommt,
- bei der Mittel vorhanden sind, mit denen Licht auf die Oberfläche des Halbleiterkörpers eingestrahlt werden kann, und
- bei der Mittel vorhanden sind, mit denen eine elektrische Spannung (39) zwischen die Elektrode (8) und den elektrischen Kontakt an den Halbleiterkörper (31) angelegt werden kann und ein elektrischer Strom zwischen der Elektrode und dem Halbleiterkörper gemessen werden kann.

3. Vorrichtung nach Anspruch 2,
bei der der Probenhalter zwischen der Kammer und einer weiteren Kammer, die je eine Meßhalbkammer (4, 5) bilden, so angebracht werden kann, daß jede Meßhalbkammer gegen die andere für den vorgesehenen Elektrolyten abgedichtet ist, oder
bei der die Kammer durch den Probenhalter in zwei Meßhalbkammern, die für den vorgesehenen Elektrolyten gegeneinander abgedichtet sind, geteilt wird.

4. Vorrichtung nach Anspruch 3,
bei der in jeder Meßhalbkammer (4, 5) je eine Elektrode (8, 15) angeordnet ist, die mit je einem nach außen geführten Anschluß versehen ist.

5. Vorrichtung nach einem der Ansprüche 1 bis 4,
die mit mehreren Probenhaltern mit Öffnungen unterschiedlicher Abmessungen ausgestattet ist.

6. Probenhalter zur Verwendung in einer Vorrichtung zur Diffusionslängenmessung in Halbleiterkörpern,
der zwei Teile (11, 12) besitzt, die jeweils einen Rahmen oder Ring mit einer darin vorhandenen Öffnung (21, 22) zur Aufnahme eines Halbleiterkörpers aufweisen und die an einander zugewandten Seitenflächen (71, 72) voneinander lösbar miteinander verbunden sind.

7. Probenhalter nach Anspruch 6,
bei dem wenigstens ein Teil (11, 12) in der dem anderen Teil zugewandten Seitenfläche (71, 72) längs eines die Öffnung (21, 22) bildenden Randes (41, 42) einen Bereich aufweist, dessen Oberfläche gegenüber der Ebene der Seitenfläche (71, 72) zurückgesetzt ist.

8. Probenhalter nach Anspruch 6 oder 7,
bei dem in jedem Teil (11, 12) in der dem anderen Teil zugewandten Seitenfläche (71, 72) längs eines die Öffnung (21, 22) bildenden Randes (41, 42) eine Nut (51, 52) vorhanden ist, in die eine Dichtung (61, 62) eingesetzt ist.

9. Probenhalter nach einem der Ansprüche 6 bis 8,
bei dem jedes Teil (11, 12) eine von dem anderen Teil abgewandte Seitenfläche besitzt, die einen ebenen Bereich aufweist, mit dem vermittels einer Dichtung (33) eine Öffnung (32) einer zur Aufnahme eines Elektrolyten (4, 5) vorgesehenen Meßhalbkammer (2, 3) einer Vorrichtung zur Diffusionslängenmessung in Halbleiterkörpern abgedichtet werden kann.
